# EUROPEAN PATENT SPECIFICATION

(11) **EP 2 946 473 B1**
(45) Date of publication and mention of the grant of the patent: **02.09.2020**
(21) Application number: 14702405.3
(22) Date of filing: 16.01.2014
(51) Int. Cl.: H03K 17/96, G06F 3/044, H03K 17/975, H03K 17/98

(54) **PHYSICAL FORCE CAPACITIVE TOUCH SENSORS**
DURCH PHYSISCHE KRAFT BEDIENBARE KAPAZITIVE BERÜHRUNGSSENSOREN
CAPTEURS TACTILES CAPACITIFS DE FORCE PHYSIQUE

(30) Priority: 17.01.2013 US 201313743678
(43) Date of publication of application: 25.11.2015
(73) Proprietor: Microchip Technology Incorporated, Chandler, AZ 85224-6199 (US)
(72) Inventor: CURTIS, Keith, Gilbert, AZ 85297 (US); DUVENHAGE, Fanie, Phoenix, AZ 85044 (US)
(74) Representative: sgb europe
(86) International application number: PCT/US2014/011800
(87) International publication number: WO 2014/113542

(56) References cited:
- WO-A1-2011/018706
- US-A1- 2006 267 598
- US-A1- 2009 058 802
- US-A1- 2010 033 354
- US-A1- 2012 217 147
- HYUNG-KEW LEE ET AL: "A Flexible Polymer Tactile Sensor: Fabrication and Modular Expandability for Large Area Deployment", JOURNAL OF MICROELECTROMECHANICAL SYSTEMS, IEEE SERVICE CENTER, US, vol. 15, no. 6, 1 December 2006 (2006-12-01), pages 1681-1686, XP011151342, ISSN: 1057-7157, DOI: 10.1109/JMEMS.2006.886021
- Yamamoto Satoshi ET AL: "Touch Mode Capacitive Pressure Sensor", , 1 January 2003 (2003-01-01), pages 45-49, XP055629852, Retrieved from the Internet: URL:https://pdfs.semanticscholar.org/fcb0/ fb9c27a65079a459ba54c0e839e880c4b90c.pdf [retrieved on 2019-10-08]

## Description

The present disclosure relates to electronic capacitive touch sensors, *e.g.,* keys, buttons, sliders, rotation, *etc.;* and more particularly, to a more secure capacitive touch sensor that requires physical force on the touch sensor during activation and further shields the sensor from extraneous unwanted activation by inadvertent proximity of a user.

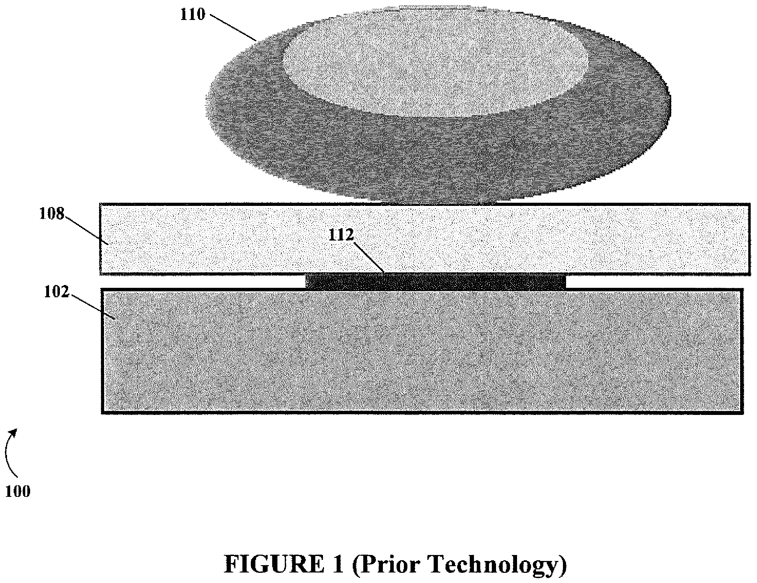

Capacitive touch sensors are used as a user interface to electronic equipment, *e.g.,* calculators, telephones, cash registers, gasoline pumps, *etc.* The capacitive touch sensors are activated (controls a signal indicating activation) by a change in capacitance of the capacitive touch sensor when an object, *e.g.,* user finger tip, causes the capacitance thereof to change. Referring to Figure 1, depicted is a prior technology capacitive touch sensor generally represented by the numeral 100. The prior technology capacitive touch sensor 100 comprises a substrate 102, a sensor element 112 and a protective covering 108, *e.g.,* glass. When a user finger tip 110 comes in close proximity to the sensor element 112, the capacitance value of the sensor element 112 changes. This capacitance change is electronically processed (not shown) so as to generate a signal indicating activation of the capacitive touch sensor 100 by the user (only finger tip 110 thereof shown). The protective covering 108 may be used to protect the sensor element 112 and for marking of the sensor 100.

Problems exist with proper operation of the sensor 100 that may be caused by water, oil, mud, and/or food products, *e.g.,* ketchup and mustard, either false triggering activation or inhibiting a desired activation thereof. Also problems exist when metallic objects (not shown) come in near proximity of the sensor element 112 and cause an undesired activation thereof. When there are a plurality of sensors 100 arranged in a matrix, *e.g.,* numeric and/or pictorial arrangement, activation of an intended one of the sensors 100 may cause a neighbor sensor(s) 100 to undesirably actuate because of the close proximity of the user finger tip 110, or other portion of the user hand (not shown). This multiple activation of more than one sensor 100 may be caused when touching the intended sensor 100 and a portion of the user's hand also is sufficiently close to adjacent neighbor sensors 100 for activation thereof.

Each capacitive touch sensor key or button comprises a capacitive sensor on a substrate, a thin dielectric spacer layer over the capacitive touch sensor, and a deformable metal target layer (*e.g.,* key or button) over the thin dielectric spacer layer. When the deformable metal target layer is depressed, the capacitance value of the capacitive sensor changes (increases).

This change in capacitance value is detected and is used to indicate that the key or button has been pressed. A problem exists however in that the deformable metal target layer is light opaque and therefore precludes backlighting thereof. Existing published solutions for capacitive touch sensor designs are mechanically very thin. They rely on simple flat spacer layers less than about 50 micrometers thick and continuous conductive metal sheets for targets that do not allow light to pass therethrough.

US Patent Application Publication US2012/0217147 discloses a physical force capacitive touch sensor having conductive plane and backlighting. US Patent Application Publication US2006/0267598 discloses a capacitive type sensor. The publication of Hyung-Kew Lee et at.: "A Flexible Polymer Tactile Sensor: Fabrication and Modular Expandability for Large Area Deployment", JOURNAL OF MICROELECTROMECHANICAL SYSTEMS, IEEE SERVICE CENTER, US, vol. 15, no. 6, 1 December 2006 (2006-12-01), pages 1681-1686, discloses modular expandable capacitive tactile sensors. US Patent Application Publication US2010/0033354 discloses a touch sensitive device. International Patent Application Publication WO2011/018706 discloses a pressure sensor with in situ offset compensation for pressure sensors. The publication "Touch Mode Capacitive Pressure Sensor", by Yamamoto et al., 1 January 2003, pages 45-49, XP055629852, Fujikura Technical Review 2003 discloses a touch mode capacitive pressure sensor.

The aforementioned problems are solved, and other and further benefits achieved by the capacitive touch sensors as defined in the independent claim. Further enhancements are characterized in the dependent claims.

According to an embodiment, the flexible cover may be light transmissive. According to a further embodiment, the electrically conductive plane may be light transmissive. According to a further embodiment, the capacitive sensor element may be light transmissive. According to a further embodiment, the substrate may be light transmissive. According to a further embodiment, the substantially non-deformable spacer may be light inhibitive.

According to a further embodiment, a light source may be provided for illuminating a face of the flexible cover. According to a further embodiment, the light source may be located between the electrically conductive plane and the flexible cover. According to a further embodiment, the light source may be located between the electrically conductive plane and the capacitive sensor element. According to a further embodiment, the light source may be located between the capacitive sensor element and the substrate. According to a further embodiment, the light source may be located on an opposite face of the substrate from which the capacitive sensor element may be located, whereby light shines through the substrate to illuminate the flexible cover.

According to a further embodiment, an alpha-numeric emblem may be provided on the flexible cover to indicate a function of an associated capacitive sensor element. According to a further embodiment, the alpha-numeric emblem may be silk screened onto the flexible cover. According to a further embodiment, the alpha-numeric emblem may be embossed into the flexible cover. According to a further embodiment, the alpha-numeric emblem may be stamped onto the flexible cover.

According to a further embodiment, the electrically conductive plane may be a layer of Indium Tin Oxide (ITO) disposed on a face of the flexible cover. According to a further embodiment, the electrically conductive plane may be a layer of Antimony Tin Oxide (ATO) disposed on a face of the flexible cover. According to a further embodiment, the electrically conductive plane may be a layer of Graphene disposed on a face of the flexible cover.

According to a further embodiment, the light source may be an electroluminescent (EL) layer. According to a further embodiment, the light source may be an organic light emitting diode (OLED) layer. According to a further embodiment, the light source may be an electrophoretic coating of light emitting material. According to a further embodiment, a light source may be located in the deformable space. According to a further embodiment, the light source may be at least one light emitting diode (LED).

According to a further embodiment, the capacitive sensor element may be coupled to an input of a capacitance value measurement circuit and the electrically conductive plane may be coupled to a power supply common or ground. According to a further embodiment, the capacitive sensor element may be coupled to a first input of a capacitance value measurement circuit, the electrically conductive plane may be coupled to second input of the capacitance value measurement circuit, and a switch may be coupled to the electrically conductive plane and a power supply common or ground, wherein when the switch may be closed the electrically conductive plane may be coupled to the power supply common or ground and when open the electrically conductive plane may be operational with the second input of the capacitance value measurement circuit.

According to a further embodiment, the substrate and the capacitive sensor element may be fabricated from a printed circuit board. According to a further embodiment, the substrate may be glass. According to a further embodiment, the substrate may be plastic. According to a further embodiment, the flexible cover may be metallic. According to a further embodiment, the flexible cover may be nonmetallic.

According to yet another embodiment, the plurality of electrodes are arranged to form a capacitive touch slider

According to a further embodiment, the plurality of mini-pedestals may be round. According to a further embodiment, the plurality of mini-pedestals may be square. According to a further embodiment, the plurality of mini-pedestals may be rectangular.

The scope of the invention is defined by the appended claims. Any reference to "embodiment(s)", "example(s)" or "aspect(s) of the invention" in this description not falling under the scope of the claims should be interpreted as illustrative example(s) for understanding the invention.

A more complete understanding of the present disclosure thereof may be acquired by referring to the following description taken in conjunction with the accompanying drawings wherein:
Figure 1 is a schematic elevational view of a cross section of a prior technology capacitive touch sensor.
Figure 2 is a schematic elevational view of a cross section of a capacitive touch sensor, according to specific example embodiments of this disclosure;
Figure 3 is a schematic plan view of a user interface arranged as a data input matrix and having a plurality of capacitive touch sensors as shown in Figure 2.
Figure 4 illustrates a schematic block diagram of an electronic system having a capacitive touch keypad, a capacitive touch analog front end and a digital processor, according to the teachings of this disclosure;
Figure 5 illustrates a schematic isometric exploded view of a capacitive touch key, according to a specific example embodiment of this disclosure;
Figure 6 illustrates a schematic isometric exploded view of a capacitive touch key, according to another specific example embodiment of this disclosure;
Figure 7 illustrates a schematic elevational view of the capacitive touch keys shown in Figures 5 and 6;
Figure 8 illustrates a schematic isometric exploded view of a capacitive touch key, according to yet another specific example embodiment of this disclosure;
Figure 9 illustrates a schematic elevational view of the capacitive touch key shown in Figure 8;
Figure 10 illustrates schematic elevational and plan views of a capacitive touch slider, according to still another specific example embodiment of this disclosure;
Figure 11 illustrates schematic plan and isometric views of the capacitive touch slider shown in Figure 10 and having a plurality of light emitting diodes for positional illumination of a touch or gesture;
Figure 12 illustrates schematic elevational and plan views of a capacitive touch circular slider, according to another specific example embodiment of this disclosure;
Figure 13 illustrates a schematic plan view of a capacitive touch pad, according to another specific example embodiment of this disclosure;
Figure 14 illustrates a schematic exploded isometric view of a capacitive touch key, according to yet another specific example embodiment of this disclosure;
Figure 15 illustrates a schematic elevational view of the capacitive touch key shown in Figure 14;
Figure 16 illustrates a schematic plan view of a capacitive touch slider, according to yet another specific example embodiment of this disclosure; and
Figure 17 illustrates schematic elevational and plan views of various additional features that may be provided with the capacitive touch key, slider and/or pad, according to the specific example embodiments of this disclosure.

While the present disclosure is susceptible to various modifications and alternative forms, specific example embodiments thereof have been shown in the drawings and are herein described in detail. It should be understood, however, that the description herein of specific example embodiments is not intended to limit the disclosure to the particular forms disclosed herein, but on the contrary, this disclosure is to cover all modifications and equivalents as defined by the appended claims.

According to the teachings of this disclosure, a capacitive touch sensor comprises a capacitive sensor element on a substrate, a physically deformable electrically insulating spacer over the capacitive sensor element, and a conductive deformable plane over the physically deformable electrically insulating spacer that is substantially parallel to the capacitive sensor element. The conductive deformable plane is connected to a power supply common and/or grounded to form a capacitor with the capacitive sensor element and for improved shielding of the capacitive sensor element from electrostatic and electromagnetic disturbances, and false triggering thereof. A protective cover may be placed over the conductive deformable plane to act as an environmental seal for improved physical and weather protection, but is not essential to operation of the capacitive touch sensor.

When the user presses down onto the approximate area of a target (e.g., alpha/numeric and/or graphical) on the conductive plan of the capacitive touch sensor, the distance between the capacitive sensor element and the conductive deformable plane is reduced, thus changing the capacitance of the capacitive sensor element. A capacitance change detection circuit monitors the capacitance value of the capacitive sensor element, and when the capacitance value changes (e.g., increases) a sensor activation signal is generated.

The capacitive touch sensor, according to the teachings of this disclosure, is substantially immune to false triggering caused by a user in close proximity to the sensor target because a correct area of the conductive deformable plane must be slightly deformed in order for the capacitance of the capacitive sensor element to change. In addition, stray metallic objects will not substantially affect the capacitance of the capacitive sensor element for the same reason. Furthermore the assembly of the capacitive touch sensor can be sealed with the physically deformable electrically insulated spacer and may thus be substantially immune to fluid contamination thereof.

A molded spacer layer and a discrete conductive metal disk may be used for a capacitive target, according to the teachings of this disclosure. By using either reverser mount or side illuminating LED(s) with a suspended metal target, capacitive touch sensor keys or buttons may be backlit. Backlighting of capacitive touch sensor keys or buttons is especially desirable for use in appliances, automotive controls, consumer products such as television set top box converters for cable or satellite television reception, security entry pads, intercom buttons, computers, industrial control panels, *etc.* Backlighting of the keys or buttons may be used to indicate that the key or button has been pressed, *e.g.,* visual feedback, and/or improved visibility under poor lighting conditions.

There are several things that are needed to complete backlighting for capacitive touch buttons. Capacitive touch buttons in most cases require that the metal deformable fascia be the target, but according to the teachings of this disclosure it would be moved away from the capacitive sensor plate to the point where it will not work as the target for changing the capacitance value of the touch sensor. To counteract this, a suspended target proximate to the capacitive sensor plate may be used. By configuring the lighted capacitive touch buttons as such, height may be added to the capacitive touch panel design that will allow placement of light emitting diodes (LEDs) on the top and/or bottom side(s) of the circuit board comprising the capacitive sensor plate.

By moving the front button layer farther from the substrate, *e.g.,* capacitive touch printed circuit board (PCB), a molded plastic layer(s) may be used for light to pass therethrough and thereby provides for backlighting of the capacitive touch sensor buttons. A metallic target layer is attached and/or molded on the plastic layer proximate to the capacitive sensor plate. As this metallic target layer moves closer to the capacitive sensor plate when the button is depressed, the capacitance of the capacitive sensor thereby changes (increases) and is detected. The metallic target layer may also be used as a shield to prevent or reduce hot (bright) spots in the lighting of the capacitive touch sensor button.

The material that holds the suspended metallic target may be translucent and function as a light pipe for transmission of light from a light source, *e.g.,* light emitting diodes (LEDs). This translucent material may also function as a seal for the holes that may now be placed in the metal cover to allow light to pass therethrough. The material that is used as the spacer surrounding the capacitive sensor plate may be of a non-translucent material so as to prevent bleeding of light from one adjacent key or button to the next.

The light source LEDs do not have to be mounted on the top side of the circuit board, as they can be mounted elsewhere as needed. Also the top layer does not have to be flat or even metal, and it may be curved or use an over-mold process for sealing of the button.

Referring now to the drawings, the details of example embodiments are schematically illustrated. Like elements in the drawings will be represented by like numbers, and similar elements will be represented by like numbers with a different lower case letter suffix.

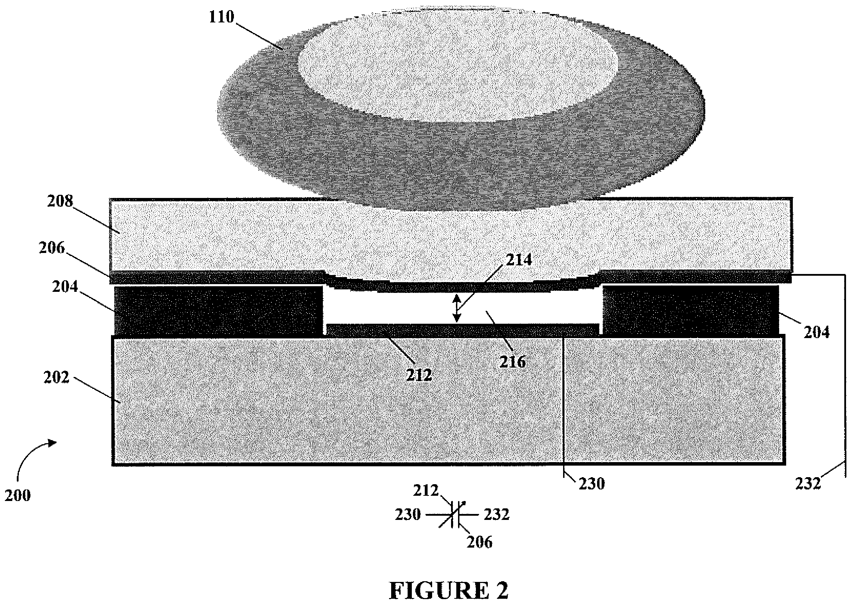

Referring to Figure 2, depicted is a schematic elevational view of a cross section of a capacitive touch sensor, according to specific example embodiments of this disclosure. The capacitive touch sensor, generally represented by the numeral 200, comprises a substrate 202, a capacitive sensor element 212, a deformable space 216, a non-deformable spacer 204, a conductive deformable plane 206 and a protective deformable cover (fascia) 208. The conductive deformable plane 206 may be connected to a power supply common and/or grounded (not shown) to form a capacitor with the capacitive sensor element 212 and for improved shielding of the capacitive sensor element 212 from electrostatic disturbances and false triggering thereof. The protective deformable cover 208 may be used as an environmental seal for improved physical and weather protection, but is not essential to operation of the capacitive touch sensor 200. The deformable space 216 may be an opening in the non-deformable spacer 204 and may be filled with, for example but not limited to, air, nitrogen, elastic silicon rubber, *etc.*

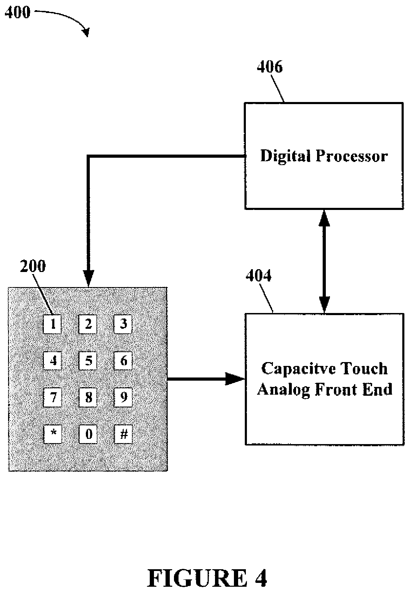

The capacitive sensor element 212 may be connected through connection 230 to a capacitance measurement circuit, *e.g.,* see Figure 4 AFE 404, and the conductive deformable plane 206 is normally connected through connection 232 to the power supply common and/or ground. However, the conductive deformable plane 206 may be connected through connection 232 to a digital output of the digital processor 406 (Figure 4) and used as both one plate of the capacitor formed with the capacitive sensor element 212 when grounded. Or the conductive deformable plane 206 may be connected to a capacitive measurement input of the AFE 404 when the digital output from the digital processor 406 is in a high impedance off state. For example the connection 232 is coupled to an input of the AFE 404 and the digital output is connected in parallel to the same input of the AFE 404. When the output is at a logic low, the conductive deformable plane 206 is at the power supply common, and when at a high impedance (off) the conductive deformable plane 206 may function as a capacitive sensor element similar to what is shown in Figure 1. E.g., the digital output acts as a shunt switch that when closed shorts the conductive deformable plane 206 to ground and when open enables conductive deformable plane 206 to function as a capacitive sensor element 112 (*e.g.,* see Figure 1). This configuration for the conductive deformable plane 206 may be used as a proximity detector, *e.g.,* as a user finger approaches the capacitive sensor (conductive deformable plane 206) a "system wakeup" signal can be generated in the digital processor 406 (Figure 4).

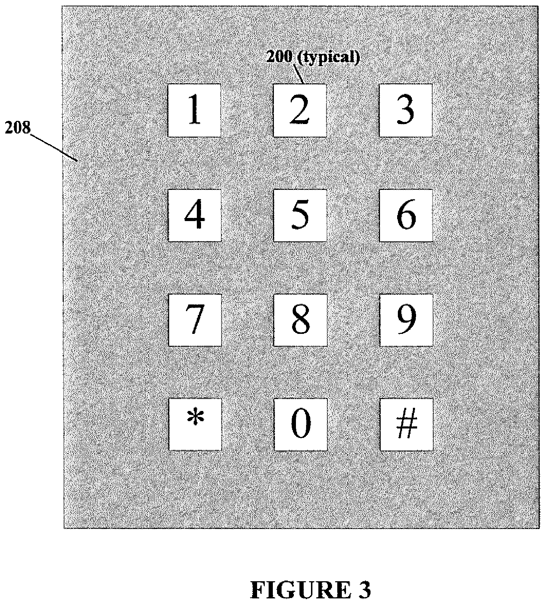

The conductive deformable plane 206 and protective deformable cover 208 are physically deformable over the deformable space 216 so that when a force, e.g., a user's finger 110, presses down onto the approximate center of a target (*e.g*., alpha/numeric and/or graphical see Figure 3) on the protective deformable cover 208 of the capacitive touch sensor 200, the distance 214 between the capacitive sensor element 212 and the conductive deformable plane 206 is reduced, thereby changing the capacitance of the capacitive sensor element 212. A capacitance change detection circuit (not shown) monitors the capacitance value of the capacitive sensor element 212, and when the capacitance value changes (*e.g*., increases) a sensor activation signal is generated (not shown). The conductive deformable plane 206 and protective deformable cover 208 may be one and the same, or the conductive deformable plane 206 may be plated, coated, attached, *etc.,* to a face of the protective deformable cover 208 proximate to the capacitive sensor element 212.

The capacitive touch sensor 200 is substantially immune to false triggering caused by a user in close proximity to the sensor target because a correct area of the conductive deformable plane 206 must be deformed in order for the capacitance of the capacitive sensor element 212 to change, *e.g.,* requires an actuation force from the user's finger 110. In addition, stray metallic objects will not substantially affect the capacitance of the capacitive sensor element 212 for the same reason. Furthermore the assembly of the capacitive touch sensor 200 can be sealed within the physically deformable electrically insulated space 216 and may thus be substantially immune to fluid contamination thereof. Also since the non-deformable spacers 204 surround the capacitive sensor element 212 and the physically deformable electrically insulated space 216, adjacent capacitive sensor elements 212 (see Figure 3) will not be affected, *e.g.,* substantially no capacitance change because the areas of the conductive deformable plane 206 over adjacent capacitive sensor elements 212 will not be substantially deformed.

The capacitive sensor element 212 is electrically conductive and may be comprised of metal such as, for example but not limited to, copper, aluminum, silver, gold, tin, and/or any combination thereof, plated or otherwise. The capacitive sensor element 212 may also be comprised of non-metallic conductive material. The substrate 202 and capacitive sensor element 212 may be, for example but are not limited to, a printed circuit board having conductive metal areas etched thereon, a ceramic substrate with conductive areas thereon, clear or translucent glass or plastic with conductive areas thereon, *etc.*

Referring to Figure 3, depicted is a schematic plan view of a user interface arranged as a data input matrix and having a plurality of capacitive touch sensors as shown in Figure 2. A plurality of capacitive touch sensors 200 are arranged in a matrix and have alpha-numeric representations indicating the functions thereof. When a mechanical force is applied any one of the capacitive touch sensors 200, a target area directly over the capacitive sensor element 212 of that one capacitive touch sensor 200 will be deformed by the mechanical force, bringing the conductive deformable plane 206 closer to the capacitive sensor element 212 and thereby changing (*e.g*., increasing) the capacitance thereof.

Referring to Figure 4, depicted is a schematic block diagram of an electronic system having a capacitive touch keypad, a capacitive touch analog front end and a digital processor, according to the teachings of this disclosure. A digital processor 406, *e.g.,* a microcontroller, microprocessor, microcomputer, digital signal processor (DSP), application specific integrated circuit (ASIC), programmable logic array (PLA), *etc.;* is coupled to a capacitive touch analog front end (AFE) 404 and a matrix of capacitive touch sensor keys 200, *e.g.,* pushbuttons, levers, toggles, targets, handles, knobs, *etc.* The digital processor 406 and AFE 404 may be part of a mixed signal (analog and digital circuits) integrated circuit device, *e.g.,* mixed signal capable microcontroller.

The capacitive touch AFE 404 facilitates, with a single low-cost integrated circuit device, all active functions used in determining when there is actuation of capacitive sensors, *e.g.,* by pressing and deflecting a target key that changes the capacitance value of an associated capacitive sensor. The capacitive touch AFE 404 measures the capacitance value of each sensor of the matrix of capacitive touch sensor keys 200 and converts the capacitance values into respective analog direct current (dc) voltages that are read and converted into digital values with an analog-to-digital converter (ADC) (not shown) and sent to the digital processor 406. Various methods of measuring capacitance change may be used. For example, but not limited to, capacitance measurement using: a charge time measurement unit (CTMU), see Microchip Application Note AN1250; a capacitive sensing module (CSM), see Microchip TB3064 "mTouch™ Projected Capacitive Touch Screen Sensing Theory of Operation"; a capacitive voltage divider (CVD) measurement, see Microchip Application Note AN1298; wherein all are available at www.microchip.com.

The digital processor 406 may supply clock and control functions to the capacitive touch AFE 404, read the analog voltage detector output of the capacitive touch AFE 404, and select each key of the matrix of capacitive touch sensor keys 200. When actuation of a key of the matrix of capacitive touch sensor keys 200 is determined, the digital processor 406 will take an appropriate action. The key (touch buttons) of the matrix of capacitive touch sensor keys 200 may be illuminated, as more fully described hereinafter.

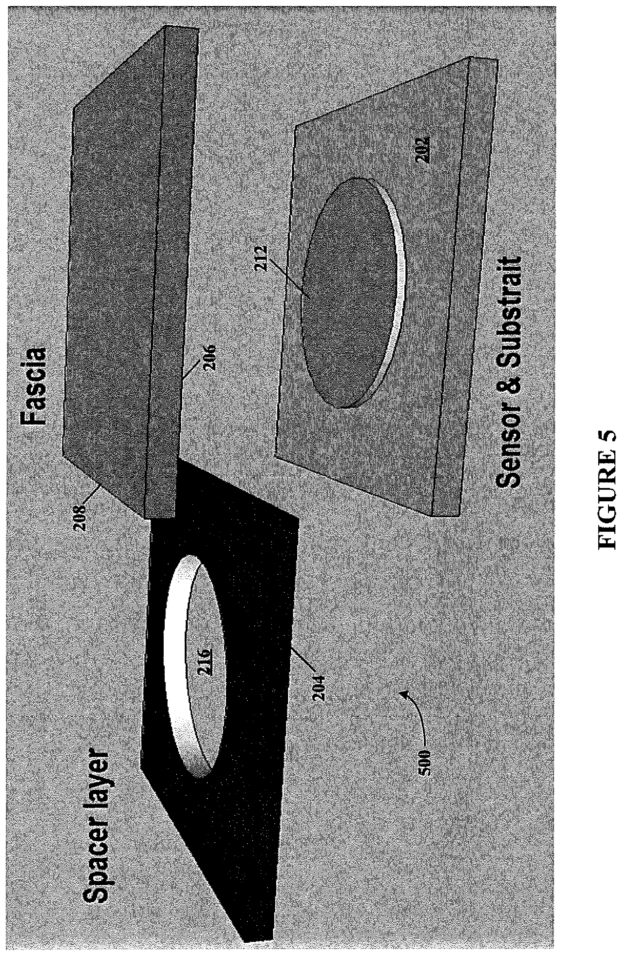

Referring to Figure 5, depicted is a schematic isometric exploded view of a capacitive touch key, according to a specific example embodiment of this disclosure. The capacitive touch sensor, generally represented by the numeral 500, comprises a substrate 202, a capacitive sensor element 212, a deformable space 216, a substantially non-deformable spacer 204, a conductive deformable plane 206 and a protective deformable cover 208. The conductive deformable plane 206 may be connected to a power supply common and/or grounded (not shown) to form a capacitor with the capacitive sensor element 212 and for improved shielding of the capacitive sensor element 212 from electrostatic disturbances and false triggering thereof. The protective deformable cover 208 may be used as an environmental seal for improved physical and weather protection, but is not essential to operation of the capacitive touch sensor 200. The deformable space 216 may be an opening in the substantially non-deformable spacer 204 and may be filled with, for example but not limited to, air, nitrogen, elastic silicon rubber, *etc.*

The conductive deformable plane 206 and protective deformable cover 208 are physically deformable over the deformable space 216 so that when a user's finger 110 presses down onto the approximate center of a target (*e.g*., alpha/numeric and/or graphical see Figure 3) on the conductive deformable plan 206 of the capacitive touch sensor 200, the distance between the capacitive sensor element 212 and the conductive deformable plane 206 is reduced, thereby changing the capacitance of the capacitive sensor element 212. A capacitance change detection circuit (not shown) monitors the capacitance value of the capacitive sensor element 212, and when the capacitance value changes (*e.g*., increases) a sensor activation signal is generated (not shown). The conductive deformable plane 206 and protective deformable cover 208 may be one and the same, or the conductive deformable plane 206 may be plated, coated, attached, *etc.,* to a face of the protective deformable cover 208 proximate to the capacitive sensor element 212.

The capacitive touch sensor 200 is substantially immune to false triggering caused by a user in close proximity to the sensor target because a correct area of the conductive deformable plane 206 must be deformed in order for the capacitance of the capacitive sensor element 212 to change, *e.g.,* requires an actuation force from the user's finger 110. In addition, stray metallic objects will not substantially affect the capacitance of the capacitive sensor element 212 for the same reason. Furthermore the assembly of the capacitive touch sensor 200 can be sealed within the physically deformable electrically insulated space 216 and may thus be substantially immune to fluid contamination thereof. Also since the substantially non-deformable spacer 204 surrounds the capacitive sensor element 212 and the physically deformable electrically insulated space 216, adjacent capacitive sensor elements 212 (see Figure 3) will not be affected, *e.g.,* no capacitance change because areas of the conductive deformable plane 206 over adjacent capacitive sensor elements 212 will not be deformed.

The capacitive sensor element 212 is electrically conductive and may be comprised of metal such as, for example but not limited to, copper, aluminum, silver, gold, tin, and/or any combination thereof, plated or otherwise. The capacitive sensor element 212 may also be comprised of non-metallic conductive material. The substrate 202 and capacitive sensor element 212 may be, for example but are not limited to, a printed circuit board having conductive metal areas etched thereon, a ceramic substrate with conductive areas thereon, clear or translucent glass or plastic with conductive areas thereon, *etc.*

The substrate 202, capacitive sensor element 212, conductive deformable plane 206 and/or protective deformable cover 208 (deformable fascia) may be light transmissive for light to pass therethrough. Non-conductive light transmissive material, *e.g.,* glass, plastic, *etc.,* may be used for the substrate 202 and the protective deformable cover 208, and conductive material, *e.g.,* indium tin oxide (ITO), antimony tin oxide (ATO), graphene, *etc.,* may be used for the capacitive sensor element 212 and conductive deformable plane 206. A light source may be positioned on an face of the substrate opposite the capacitive sensor element 212 and/or inside of the deformable space 216.

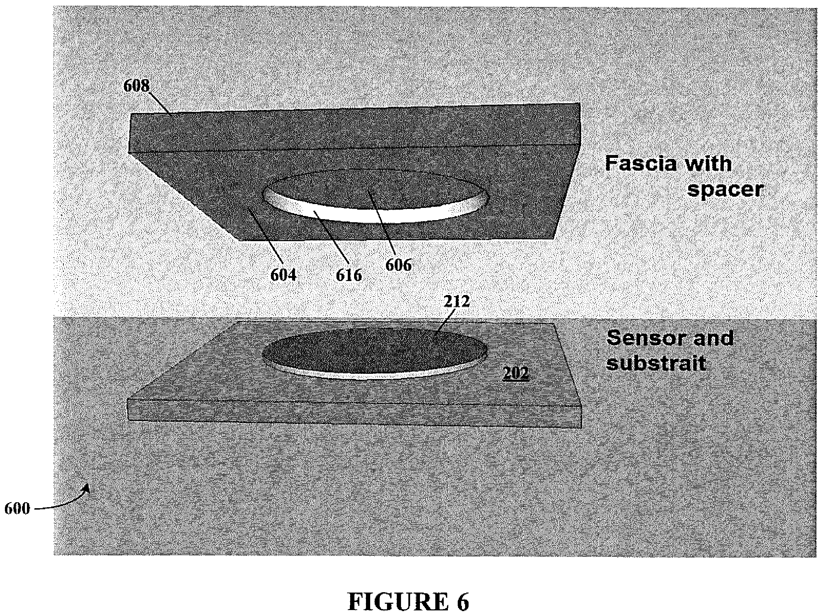

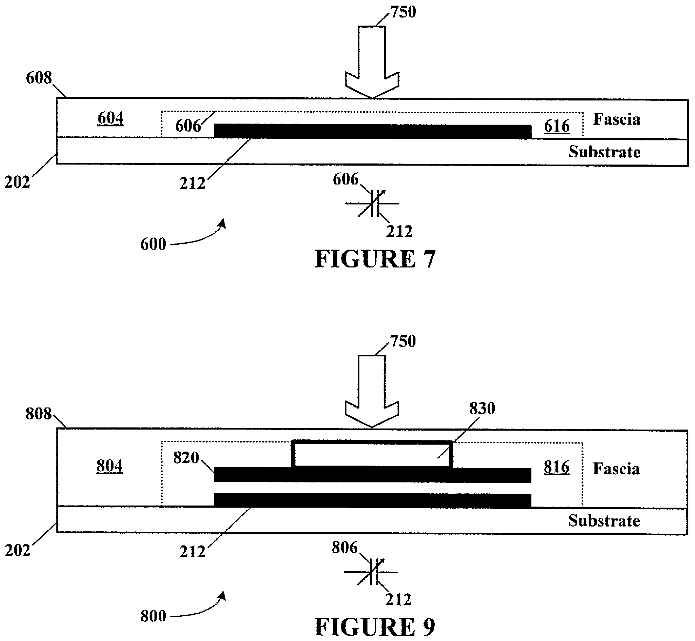

Referring to Figures 6 and 7, depicted are schematic isometric exploded and elevational views, respectively, of a capacitive touch key, according to another specific example embodiment of this disclosure. The capacitive touch sensor, generally represented by the numeral 600, comprises a substrate 202, a capacitive sensor element 212, a substantially non-deformable spacer 604, and a deformable cover 608 (fascia). The deformable cover 608 has a deformable space 216 formed therein and a conductive deformable plane 606 thereon. Formation of the deformable space 616 in the deformable cover 608 may be by, for example but limited to, etching, stamping, milling, *etc.* The conductive deformable plane 606 may be part of a portion of a face of the deformable cover 608 proximate to the capacitive sensor element 212 if the deformable cover 608 is conductive, or may be a conductive material that is, for example but is limited to, plated, painted, vapor disposed, *etc.,* onto the face of the deformable cover 608.

The portion of the deformable cover 608 having the space 616 formed therein is deformable (flexible) so that the conductive deformable plane 606 will be moved towards the capacitive sensor element 212 when force 750 is applied to that portion of the deformable cover 608. The other portion of the deformable cover 608 over the substantially non-deformable spacer 604 is not as flexible as the portion over the deformable space 616 and will not deform as much, thereby isolating any capacitive change to the capacitive sensor element 212 under just the portion of the deformable fascia cover 608 having the force 750 applied thereto.

The deformable cover 608 may be used as an environmental seal for improved physical and weather protection. The deformable cover 608 may be light transmissive, and may have selectable areas thereof illuminated based upon actuation of capacitive sensor elements 212 in those areas. The substrate 202 may also be light transmissive. Materials for the deformable cover 608, conductive deformable plane 606, capacitive sensor element 212 and substrate 202 may be as described more fully hereinabove.

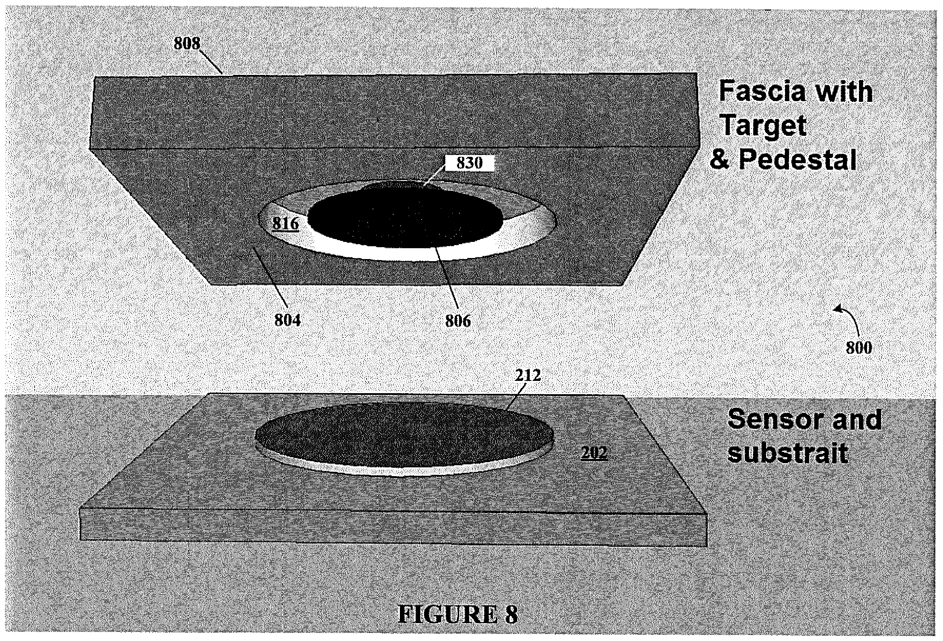

Referring to Figures 8 and 9, depicted are schematic isometric exploded and elevational views, respectively, of a capacitive touch key, according to yet another specific example embodiment of this disclosure. The capacitive touch sensor, generally represented by the numeral 800, comprises a substrate 202, a capacitive sensor element 212, a substantially non-deformable spacer 804, a conductive plane 820 (target), a pedestal 830 and a deformable cover 808. Formation of the deformable space 816 in the deformable cover 808 may be by, for example but limited to, etching, stamping, milling, *etc.* The pedestal 830 may be attached to an inside face of the deformable cover 808 and inside of the space 816. The conductive plane 820 (target) may be attached to the pedestal 830 and located between the pedestal 830 and the capacitive sensor element 212.

The portion of the deformable cover 808 having the space 816 formed therein is deformable (flexible) so that the conductive plane 820 and pedestal 830 will move towards the capacitive sensor element 212 when force 750 is applied to that portion of the deformable cover 808. The other portion of the deformable cover 808 over the spacer 804 is not as flexible as the portion over the space 816 and will not deform as much, thereby isolating any capacitive change to the capacitive sensor element 212 under just the portion of the deformable cover 808 having the force 750 applied thereto.

The deformable cover 808 may be used as an environmental seal for improved physical and weather protection. The deformable cover 808 may be light transmissive, and may have selectable areas thereof illuminated based upon actuation of capacitive sensor elements 212 in those areas. The substrate 202 may also be light transmissive. Materials for the deformable cover 808, conductive plane 820, capacitive sensor element 212 and substrate 202 may be as described more fully hereinabove. The pedestal 830 allows more room in the space 816 (more height) and use of a thin and opaque conductive material for the conductive plane 820. A light source (not shown) may be placed in the space 816 and light will be dispersed therein so as to light up the portion of the deformable cover 808 over the space 816.

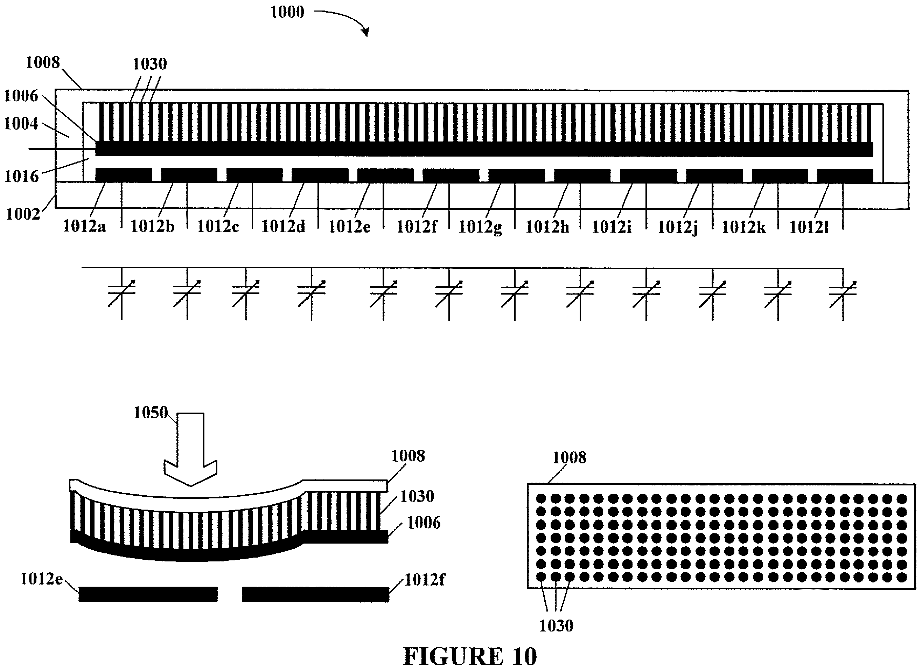

Referring to Figure 10, depicted are schematic elevational and plan views of a capacitive touch slider, according to still another specific example embodiment of this disclosure. The capacitive touch slider, generally represented by the numeral 1000, comprises a substrate 1002, a plurality of capacitive sensor elements 1012, a conductive deformable plane 1006, a substantially non-deformable spacer 1004, a plurality of mini-pedestals 1030, a protective deformable cover 1008 and a deformable space 1016. The plurality of mini-pedestals 1030 may be attached to an inside face of the deformable cover 1008 and inside of the space 1016. The conductive deformable plane 1006 may be attached to the plurality of mini-pedestals 1030 and located between the plurality of mini-pedestals 1030 and the plurality of capacitive sensor elements 1012.

The deformable cover 1008 is flexible so that a portion of the conductive deformable plane 1006 and a portion of the plurality of mini-pedestals 1030 will move toward at least one of the plurality of capacitive sensor elements 1012 when a force 1050 is applied to that portion of the deformable cover 1008. The capacitance value(s) of at least one of the plurality of capacitive sensor elements 1012 will thereby change, *e.g.,* increase, and detection of this capacitance change may be done with a detection circuit similar to the one shown in Figure 4. Depending upon the location of the force 1050, more than one of the plurality of capacitive sensor elements 1012 may change capacitance values. A finer granularity positional location of the force 1050 applied may be determined by the capacitance value changes of these more than one of the plurality of capacitive sensor elements 1012, *e.g.,* taking the ratio-metric capacitance values thereof.

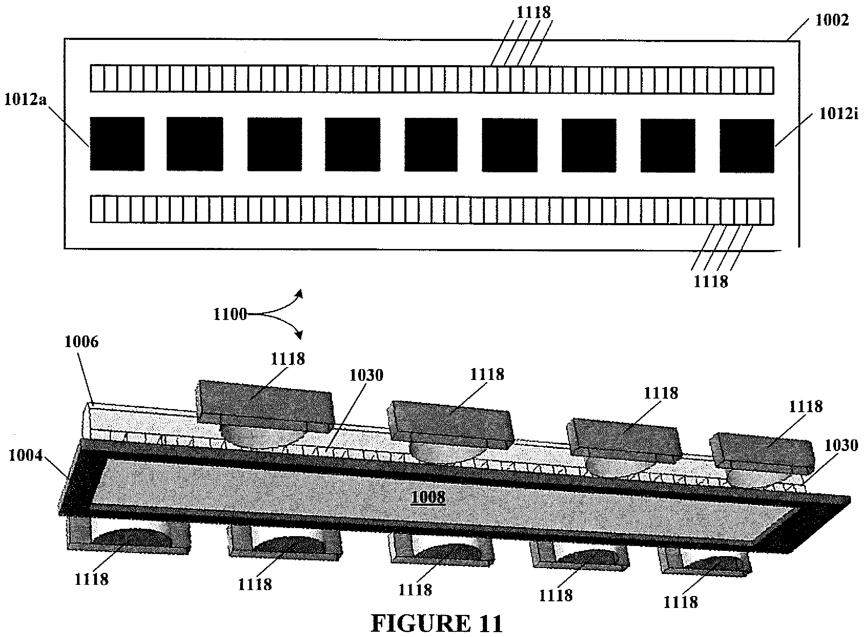

The deformable cover 1008 may be used as an environmental seal for improved physical and weather protection. The deformable cover 1008 may be light transmissive, and may have selectable areas thereof illuminated based upon actuation of the plurality of capacitive sensor elements 1012 in those areas. The substrate 1002 may also be light transmissive. Materials for the deformable cover 1008, conductive deformable plane 1006, plurality of capacitive sensor elements 1012 and substrate 1002 may be as described more fully hereinabove. At least one light source (see Figure 11) may be placed in the space 1016 and light may be dispersed therein so as to light up that portion of the deformable cover 1008 having the force 1050 applied thereto.

The plurality of mini-pedestals 1030 may be of any number, shape or size, *e.g.,* round, square, rectangular, *etc.* Improved granularity of positional location force determination may be obtained by using a greater number and smaller size for the plurality of mini-pedestals 1030. Comparison of the capacitance value changes of adjacent ones of the plurality of capacitive sensor elements 1012 may be used in more precisely locating a smaller area of the deformable cover 1008 than the area of a single one of the plurality of capacitive sensor elements 1012, e.g., ratio-metric comparison of the capacitance values of adjacent ones of the plurality of capacitive sensor elements 1012.

Referring to Figure 11, depicted are schematic plan and isometric views of the capacitive touch slider shown in Figure 10 and having a plurality of light emitting diodes for positional illumination of a touch or gesture. Light sources 1118, *e.g.,* light emitting diodes (LEDs) may be placed adjacent the plurality of capacitive sensor elements 1012, and used as illumination and/or visual feedback of the location(s) of the touch or gesture force.

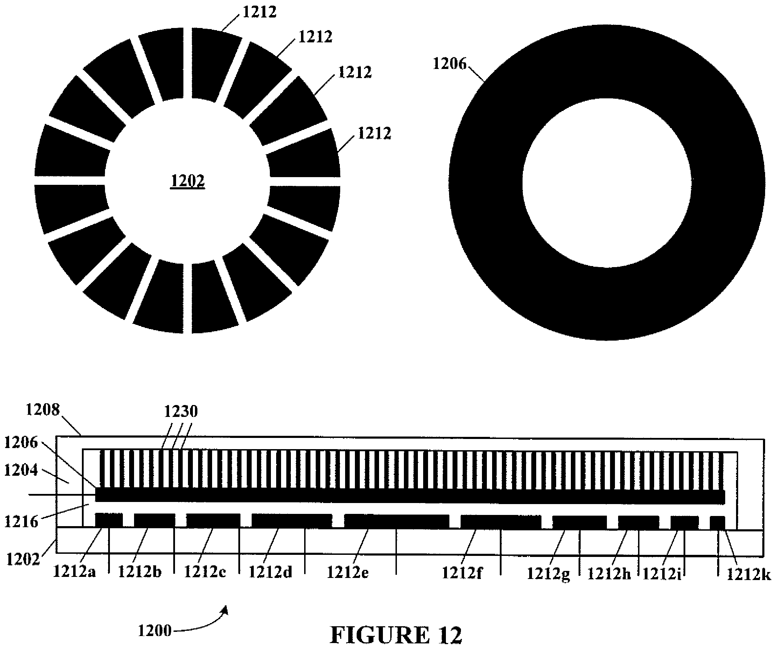

Referring to Figure 12, depicted are schematic elevational and plan views of a capacitive touch circular slider, according to another specific example embodiment of this disclosure. The capacitive touch circular slider, generally represented by the numeral 1200, comprises a substrate 1202, a plurality of capacitive sensor elements 1212, a conductive deformable plane 1206, a substantially non-deformable spacer 1204, a plurality of mini-pedestals 1230, a protective deformable cover 1208 and a deformable space 1216. The plurality of mini-pedestals 1230 may be attached to an inside face of the deformable cover 1208 and inside of the space 1216. The conductive deformable plane 1206 may be attached to the plurality of mini-pedestals 1230 and located between the plurality of mini-pedestals 1230 and the plurality of capacitive sensor elements 1212.

The deformable cover 1208 is flexible so that a portion of the conductive deformable plane 1206 and a portion of the plurality of mini-pedestals 1230 will move toward at least one of the plurality of capacitive sensor elements 1312 when a force (1050) is applied to that portion of the deformable cover 1308. The capacitance value(s) of at least one of the plurality of capacitive sensor elements 1312 will thereby change, *e.g.,* increase, and detection of this capacitance change may be done with a detection circuit similar to the one shown in Figure 4. Depending upon the location of the force (1050), more than one of the plurality of capacitive sensor elements 1212 may change capacitance values. A finer granularity positional location of the force (1050) applied may be determined by the capacitance value changes of these more than one of the plurality of capacitive sensor elements 1212, *e.g.,* taking the ratio-metric capacitance values thereof.

The deformable cover 1208 may be used as an environmental seal for improved physical and weather protection. The deformable cover 1208 may be light transmissive, and may have selectable areas thereof illuminated based upon actuation of the plurality of capacitive sensor elements 1212 in those areas. The substrate 1202 may also be light transmissive. Materials for the deformable cover 1208, conductive deformable plane 1206, plurality of capacitive sensor elements 1212 and substrate 1202 may be as described more fully hereinabove. At least one light source (see Figure 11) may be placed in the space 1216 and light may be dispersed therein so as to light up that portion of the deformable cover 1208 having the force (1050) applied thereto.

The plurality of mini-pedestals 1230 may be of any number, shape or size, *e.g.,* round, square, rectangular, *etc.* Improved granularity of positional location force determination may be obtained by using a greater number and smaller size for the plurality of mini-pedestals 1230. Comparison of the capacitance value changes of adjacent ones of the plurality of capacitive sensor elements 1212 may be used in more precisely locating a smaller area of the deformable cover 1208 than the area of a single one of the plurality of capacitive sensor elements 1212, e.g., ratio-metric comparison of the capacitance values of adjacent ones of the plurality of capacitive sensor elements 1212. It is contemplated and within the scope of this disclosure that the shape of the capacitive touch circular slider 1200 may be, for example but not limited to, oval, ellipsoid, square, triangular, *etc.*

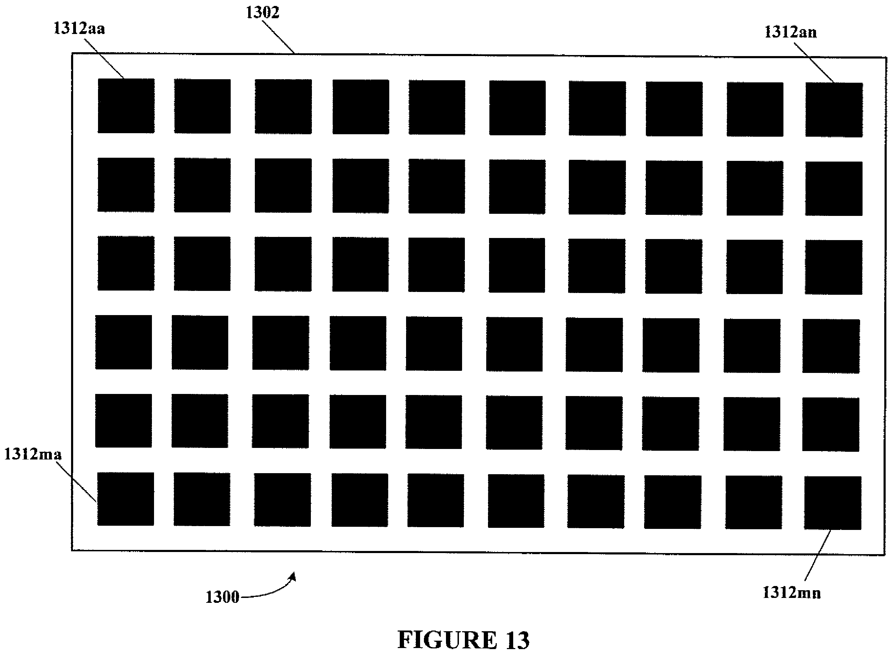

Referring to Figure 13, depicted is a schematic plan view of a capacitive touch pad, according to another specific example embodiment of this disclosure. The capacitive touch pad, generally represented by the numeral 1300, comprises a substrate 1302, a plurality of capacitive sensor elements 1312 arranged in an m x n matrix, a substantially non-deformable spacer (e.g., similar to the spacer 1004 shown in Figure 10) surrounding the plurality of capacitive sensor elements 1312, a conductive deformable plane (*e.g*., similar to plane 1006 shown in Figure 10), a plurality of mini-pedestals (*e.g.*, similar to the plurality of mini-pedestals 1030 shown in Figure 10), and a protective deformable cover (*e.g*., similar to the protective deformable cover 1008 of Figure 10) and a deformable space (*e.g.*, similar to the deformable space 1016 shown in Figure 10). The plurality of mini-pedestals may be attached to an inside face of the deformable cover and inside of the space. The conductive deformable plane may be attached to the plurality of mini-pedestals and located between the plurality of mini-pedestals and the plurality of capacitive sensor elements 1312. The capacitive touch pad 1300 operates in substantially the same way as the capacitive touch sliders 1000 and 1200 shown in Figures 10-12 and described more fully hereinabove. Similar elements thereof will be referenced as appropriate numbers in parenthesis hereinafter.

The deformable cover (1008) is flexible so that a portion of the conductive deformable plane (1006) and a portion of the plurality of mini-pedestals (1030) will move toward at least one of the plurality of capacitive sensor elements 1312 when a force (1050) is applied to that portion of the deformable cover (1008). The capacitance value(s) of at least one of the plurality of capacitive sensor elements 1312 will thereby change, e.g., increase, and detection of this capacitance change may be done with a detection circuit similar to the one shown in Figure 4. Depending upon the location of the force (1050), more than one of the plurality of capacitive sensor elements 1312 may change capacitance values. A finer granularity positional location of the force (1050) applied may be determined by the capacitance value changes of these more than one of the plurality of capacitive sensor elements 1312, *e.g.,* taking the ratio-metric capacitance values thereof.

The deformable cover (1008) may be used as an environmental seal for improved physical and weather protection. The deformable cover (1008) may be light transmissive, and may have selectable areas thereof illuminated based upon actuation of the plurality of capacitive sensor elements 1312 in those areas. The substrate 1302 may also be light transmissive. Materials for the deformable cover (1008), conductive deformable plane (1006), plurality of capacitive sensor elements 1312 and substrate 1302 may be as described more fully hereinabove. At least one light source (see Figure 11) may be placed in the space (1016) and light will be dispersed therein so as to light up that portion of the deformable cover (1008) having the force (1050) applied thereto.

The plurality of mini-pedestals (1030) may be of any number, shape or size, *e.g.,* round, square, rectangular, *etc.* Improved granularity of positional location force determination may be obtained by using a greater number and smaller size for the plurality of mini-pedestals (1030). Comparison of the capacitance value changes of adjacent ones of the plurality of capacitive sensor elements 1312 may be used in more precisely locating a smaller area of the deformable cover (1008) than the area of a single one of the plurality of capacitive sensor elements 1312, *e.g.,* ratio-metric comparison of the capacitance values of adjacent ones of the plurality of capacitive sensor elements 1312.

The capacitive touch sliders 1000 and 1200 may be utilized as a linear control like an analog slider, *e.g.,* potentiometer, light dimmer, volume control, *etc.* The capacitive touch pad 1300 may be utilized in the same fashion as the capacitive touch sliders 1000 and 1200 with the additional capabilities of a two dimensional tablet. It is contemplated and within the scope of this disclosure that both the capacitive touch sliders 1000 and 1200, and the capacitive touch pad 1300 may be used to detect both force touches and force gestures on and across the deformable cover that affects capacitance value changes in at least one of the plurality of capacitive sensor elements 1012, 1212, 1312.

It is contemplated and within the scope of this disclosure that the capacitive touch pad may be shaped into a cylinder, wherein the plurality of capacitive sensor elements are mounted around the circumference of a cylindrical substrate with a deformable (flexible) outer cylindrical cover therearound so that when held in a user's hand the fingers of the user will change the capacitance values of certain ones of the plurality of capacitive sensor elements 1312, e.g., whereby when the user squeezes the cylindrical outer cover and rotates the hand the certain ones of the plurality of capacitive sensor elements will change capacitance values thereof and may be used in determining hand rotation and location thereon.

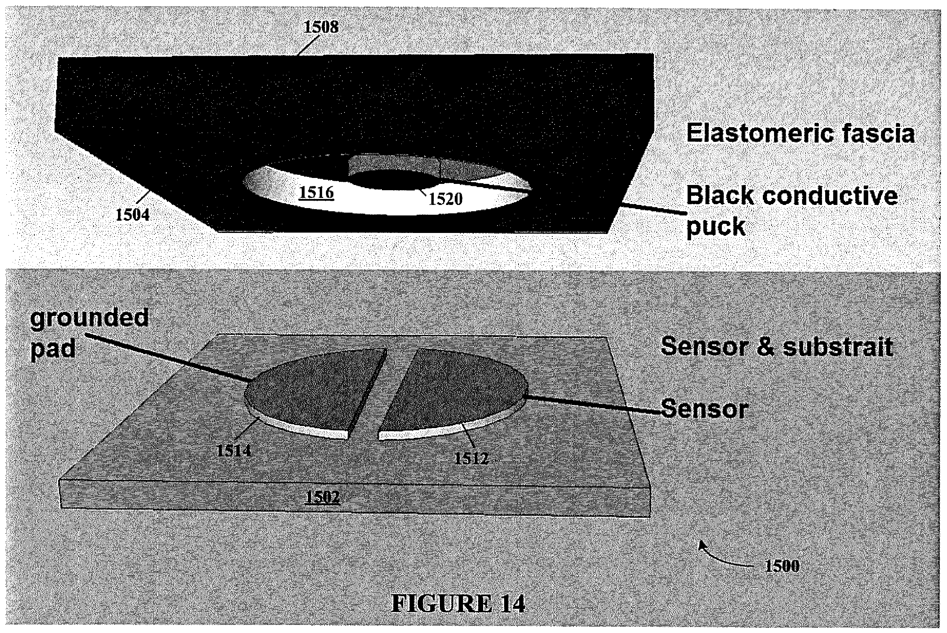

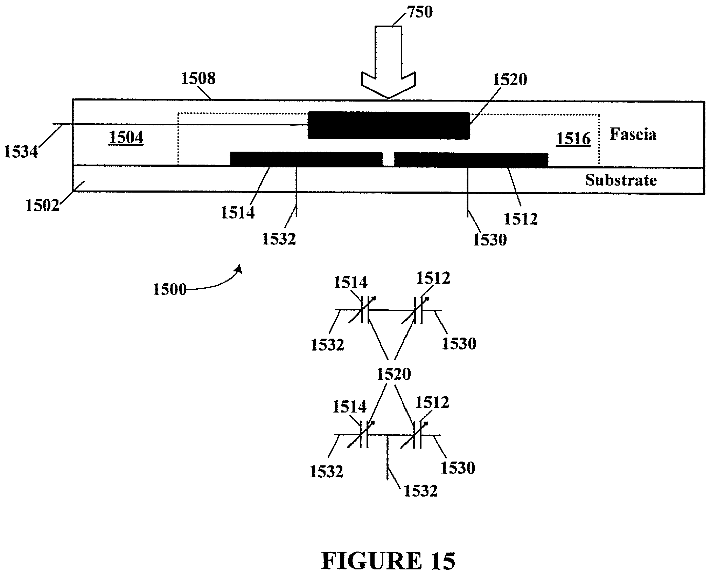

Referring to Figures 14 and 15, depicted are schematic exploded isometric and elevational views, respectively, of a capacitive touch key, according to yet another specific example embodiment of this disclosure. The capacitive touch sensor, generally represented by the numeral 1500, comprises a substrate 1502, a first capacitive sensor element 1512, a second capacitive sensor element 1514, a substantially non-deformable spacer 1504, a conductive plane/pedestal 1520 (puck) and a deformable cover 1508. Formation of the deformable space 1516 in the deformable cover 1508 may be by, for example but limited to, etching, stamping, milling, *etc.* The conductive plane/pedestal 1520 may be attached to an inside face of the deformable cover 1508, inside of the space 1516, and over the first and second capacitive sensor elements 1512 and 1514.

The portion of the deformable cover 1508 having the space 1516 formed therein is flexible so that the conductive plane/pedestal 1520 will move towards the first and second capacitive sensor elements 1512 and 1514 when force 750 is applied to that portion of the deformable cover 1508. The other portion of the deformable cover 1508 over the spacer 1504 is not as flexible as the portion over the space 1516 and will not deform as much, thereby isolating any capacitive change to the first and second capacitive sensor elements 1512 and 1514 under just the portion of the deformable cover 1508 having the force 750 applied thereto.

The first capacitive sensor element 1512 may be coupled to an input of the AFE 404 and the second capacitive sensor element 1514 may be coupled to a supply common or ground. If the conductive plane/pedestal 1520 is not connected to anything, it acts as a coupling plate between the first and second capacitive sensor elements 1512 and 1514. However, If the conductive plane/pedestal 1520 is connected to a supply common or ground 1534, then the first and second capacitive sensor elements 1512 and 1514 may be independently connected to the AFE 404 and a slider arrangement and operation is possible as shown in Figure 10 and described more fully hereinabove.

The deformable cover 1508 may be used as an environmental seal for improved physical and weather protection. The deformable cover 1508 may be light transmissive, and may have selectable areas thereof illuminated based upon actuation of the first and second capacitive sensor elements 1512 and 1514 in those areas. The substrate 1502 may also be light transmissive. Materials for the deformable cover 1508, conductive plane/pedestal 1520, capacitive sensor elements 1512 and 1514, and substrate 1502 may be as described more fully hereinabove. A light source (not shown) may be placed in the space 1516 and light will be dispersed therein so as to light up the portion of the deformable cover 1508 over the space 1516.

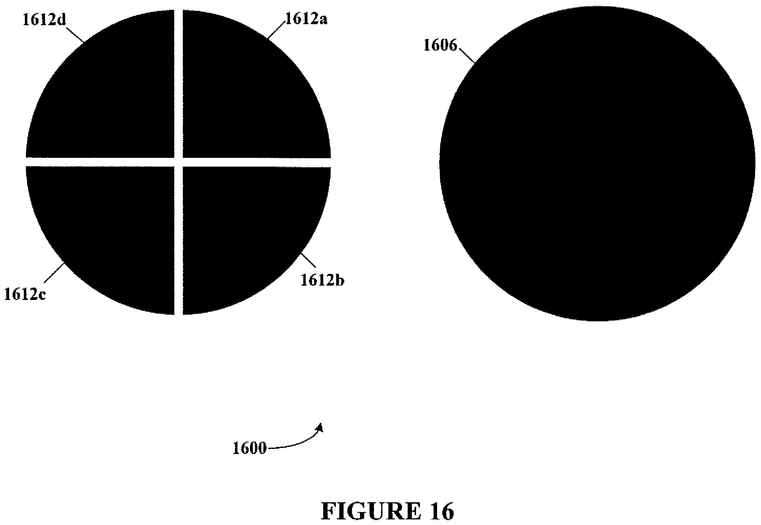

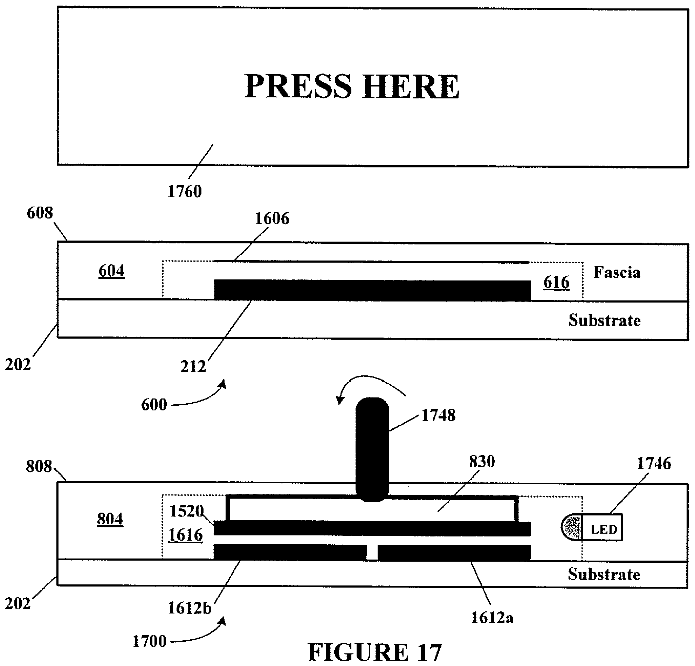

Referring to Figure 16, depicted is a schematic plan view of a capacitive touch slider, according to yet another specific example embodiment of this disclosure. The capacitive touch slider, generally represented by the numeral 1600, comprises substantially the same elements as the capacitive touch sensor 1500 shown in Figures 14 and 15 above, with the addition of at least three capacitive sensor elements 1612 (four sensor elements shown in Figure 16). The conductive plane/pedestal 1520 (puck) may be over and proximate to the at least three capacitive sensor elements 1612. The conductive plane/pedestal 1520 (puck) may also be replaced by a conductive deformable plane 1606 and a plurality of mini-pedestals (1030) such as depicted in Figure 10. The capacitive touch slider 1600 may be used as, for example but is not limited to, a joystick 1748 (see Figure 17), a computer touch pad or mouse, *etc.* It is contemplated and within the scope of this disclosure that the capacitive sensor elements 1612, and the conductive plane/pedestal 1520 (puck) or conductive deformable plane 1606 may by fabricated into any shape(s).

Referring to Figure 17, depicted are schematic elevational and plan views of various additional features that may be provided with the capacitive touch key, slider and/or pad, according to the specific example embodiments of this disclosure. Any or all of the aforementioned embodiments may be provided with any one or more of the following additional features. A "joy stick" 1748 may be attached to a pedestal 830 which may be attached to a metal target 1620. When the joy stick 1748 is moved, the pedestal 830 and target 1620 will move proportionally. Movement of the target 1620 will change the capacitance values of the capacitance sensors 1612a and 1612b (more than two sensors 1612 may be utilized). A light source, *e.g.,* light emitting diode 1746, electroluminescent layer, organic light emitting diode (OLED) layer, electrophoretic layer, *etc.* Alpha-numeric labels 1760 may be provided on the fascia 608 to identify the function of the capacitive touch key.

An OLED (organic light-emitting diode) is a light-emitting diode (LED) in which the emissive electroluminescent layer is a film of organic compounds which emit light in response to an electric current. This layer of organic semiconductor material is situated between two electrodes. Generally, at least one of these electrodes is transparent. Electroluminescence (EL) is an optical phenomenon and electrical phenomenon in which a material emits light in response to the passage of an electric current or to a strong electric field.

A feature of the present invention may be a metal target (820) attached to a pedestal (830). Another feature may be a light source, *e.g.,* light emitting diode (LED) 1746, for back lighting (face) fascia legends. Another feature is a film layer for the fascia and the conductive deformable plane comprising a visually clear, conductive layer of Indium Tin Oxide (ITO), Antimony Tin Oxide (ATO) or Graphene deposited onto a face of the fascia proximate to the capacitive sensor by sputtering, silk screening, *etc.* Another feature is silk screening a visually opaque, electrically conductive layer of silver ink for the conductive deformable plane that is printed to leave openings for back lighting therethrough.

Another feature is providing a light source layer between the capacitive sensor element and the conductive deformable plane. Another feature is providing an electroluminescent layer for back lighting the capacitive touch key and located between the target and fascia. Another feature is providing an organic light emitting diode (OLED) layer for back lighting the capacitive touch key and located between the target and fascia. Another feature is providing an electrophoretic layer for back lighting the capacitive touch key and located between the target and fascia.

Another feature is providing micro-perforated target and/or fascia layer for allowing light to pass therethrough. Another feature is providing a lighting layer behind the capacitive sensor element and providing light through openings in the capacitive sensor element. Another feature is providing a lighting layer behind the substrate and providing light through openings in the substrate and capacitive sensor element.

Another feature is a button system comprising a conductive target layer bonded to a spacer layer and having an opening over a capacitive sensor element. Another feature is marking a target layer to show a location and function of the capacitive touch key associated therewith. Another feature is adding a plastic layer over the target layer to form a fascia with markings to show the location and function of the capacitive touch key associated therewith.

Another feature is providing two touch key buttons shaped like overlapping triangles to form a slider function. Another feature is providing a plurality of capacitive sensor elements formed into a circular slider. Another feature is providing a plurality of capacitive sensor elements formed into an X-Y matrix for use as a positional input system. Another feature is providing a target layer comprising a continuous conductive sheet, capacitively coupled to a ground plane surrounding the capacitive sensor elements. Another feature is providing a target layer comprising a continuous conductive sheet, capacitively coupled to a ground plane for improved noise immunity. Another feature is providing a target isolation layer, one above each capacitive sensor element, with each sensor element divided in half whereby a first half is coupled to a power supply common or ground and the second half acts as the capacitive sensor element.

Another feature is providing the spacer layer as a double sided adhesive sheet. Another feature is providing the spacer layer as an additional layer in a multilayer printed circuit board. Another feature is providing a spacer layer implemented as an etched pocket in an underside of a target layer. Another feature is providing a spacer layer implemented as a machined pocket in a plastic fascia and a target layer implemented as a conductive plated pedestal. Another feature is providing a target implemented as a metal disc fastened to a pedestal. Another feature is providing a target implemented as a metal snap dome, actuated by a pedestal.

Another feature is providing two capacitive sensor elements, one at each end of a vertical rib. As the rib is pressed by a user's finger, the force on the two sensors is divided proportionally to the position of the user's finger, thereby creating a slider function with only two capacitive sensor elements.

Another feature is providing at least three capacitive sensor elements mounted around a circumference of a cylinder with a flexible cylinder target surrounding the at least three capacitive sensor elements. When a user squeezes the outer cylinder with his hand and then rotates the hand around the outer cylinder, the at least three capacitive sensor elements will detect the moving deflection of the cylinder target as the fingers of the hand rotate therearound. A further feature is using the outer cylinder for back/right/left detection to create a three axis detector. Still a further feature is moving the outer cylinder up/down to create a four axis detector.

Another feature is detecting capacitance value change of the capacitive sensor element(s) with a charge time measurement unit (CTMU). Another feature is detecting capacitance value change of the capacitive sensor element(s) with a capacitive sensing module (CSM). Another feature is detecting capacitance value change of the capacitive sensor element(s) with a capacitive voltage divider (CVD). Another feature is detecting capacitance value change of the capacitive sensor element(s) with a charge balancing detector. Another feature is detecting capacitance value change of the capacitive sensor element(s) with a mutual capacitance detector.

Another feature is coupling a target layer to a capacitive touch input and a digital output driver for providing a grounded target layer or use as a proximity detector, wherein when the digital output driver is at a logic low the target layer is at a power supply common or ground and when at a high impedance (off) the target layer may be used to detect the presence of an object (*e.g.,* finger).

## Claims

1. A physical force capacitive touch sensor, comprising:
a substrate (1002);
a capacitive sensor element on a face of the substrate (1002) comprising a plurality of electrodes (1012; 1212);
a cover (1008; 1208) comprising a first section (1004; 1204) forming a substantially non-deformable spacer on the substrate (1002) that surrounds the capacitive sensor element (1012; 1212) and a second section forming a flexible cover covering the capacitive sensor element (1012; 1212); and
an electrically conductive plane (1006; 1206) coupled with the flexible cover via a plurality of pedestals (1030; 1230) and being proximate to the capacitive sensor element (1012; 1212) and being arranged to at least partly cover each electrode of said plurality of electrodes (1012; 1212);
wherein a density of pedestals (1030; 1230) coupled between the flexible cover (1008; 1208) and the electrically conductive plane (1006; 1206) is greater than a density of electrodes of the plurality of electrodes (1012; 1212); and
wherein when a mechanical force is applied to the flexible cover (1008), the flexible cover (1008; 1208) and the electrically conductive plane (1006; 1206) are biased toward the capacitive sensor element (1012; 1212), whereby the capacitive sensor element (1012; 1212) changes capacitance value.

2. The physical force capacitive touch sensor according to claim 1, wherein the cover is a single piece cover (1008; 1208) and the electrically conductive plane (1006; 1206) is a part of the single piece cover (1008; 1208).

3. The physical force capacitive touch sensor according to claim 1, wherein the plurality of electrodes (1012; 1212) are arranged to form a slider.

4. The physical force capacitive touch sensor according to claim 1, wherein the plurality of pedestals (1030) are arranged in matrix.

5. The physical force capacitive touch sensor according to claim 1, wherein the plurality of pedestals (1030; 1230) are round, square, or rectangular.

6. The physical force capacitive touch sensor according to claim 4 or 5, wherein the plurality of capacitive sensor elements (1212) are arranged to form a ring and the electrically conductive plane (1206) is ring-shaped.

7. The physical force capacitive touch sensor according to claim 4, wherein a deformable space (1016; 1206) around the capacitive sensor element (1012; 1212) is created by the flexible cover and the substantially non-deformable spacer (1004; 1204), wherein the flexible cover is light transmissive and the deformable space comprises a light source, wherein the light source is preferably at least one light emitting diode (LED).

8. The physical force capacitive touch sensor according to one of the preceding claims, wherein at least one of the electrically conductive plane (1006; 1206), the capacitive sensor element (1012; 1212), or the substrate (1002) is light transmissive and the substantially non-deformable spacer (1004; 1204) is light inhibitive.

9. The physical force capacitive touch sensor according to any of the claims 1 to 6 and 8, further comprising a light source, preferably an electroluminescent (EL) layer or an organic light emitting diode (OLED) layer or an electrophoretic coating of light emitting material, for illuminating a face of the flexible cover.

10. The physical force capacitive touch sensor according to claim 9, wherein the light source is located between the electrically conductive plane (1006; 1206) and the flexible cover or between the electrically conductive plane (1006; 1206) and the capacitive sensor element (1012; 1212) or between the capacitive sensor element (1012; 1212) and the substrate (1002) or on an opposite face of the substrate (1002) from which the capacitive sensor element (1012; 1212) is located, whereby light shines through the substrate (1002) to illuminate the flexible cover.

11. The physical force capacitive touch sensor according to one of the preceding claims, further comprising an alpha-numeric emblem on the flexible cover to indicate a function of an associated capacitive sensor element (1012; 1212), preferably wherein the alpha-numeric emblem is silk screened onto the flexible cover or the alpha-numeric emblem is embossed into the flexible cover or the alpha-numeric emblem is stamped onto the flexible cover.

12. The physical force capacitive touch sensor according to one of the preceding claims, wherein the electrically conductive plane (1006) is a layer of Indium Tin Oxide (ITO) disposed on a face of the flexible cover or a layer of Antimony Tin Oxide (ATO) disposed on a face of the flexible cover or a layer of Graphene disposed on a face of the flexible cover.

13. The physical force capacitive touch sensor according to one of the preceding claims, wherein the capacitive sensor element (1012; 1212) is coupled to an input of a capacitance value measurement circuit (404) and the electrically conductive plane (1006; 1206) is coupled to a power supply common or ground, or
wherein the capacitive sensor element (1012; 1212) is coupled to a first input of a capacitance value measurement circuit (404), the electrically conductive plane (1006; 1206) is coupled to a second input of the capacitance value measurement circuit (404), and a switch is coupled to the electrically conductive plane and a power supply common or ground, wherein when the switch is closed the electrically conductive plane (1006; 1206) is coupled to the power supply common or ground and when open the electrically conductive plane is operational with the second input of the capacitance value measurement circuit (404).

14. The physical force capacitive touch sensor according to one of the preceding claims, wherein the substrate (1002) and the capacitive sensor element (1012) are fabricated from a printed circuit board or wherein the substrate (1002) is glass, plastic, metallic, or nonmetallic.

15. A user interface having a plurality of physical force capacitive touch sensors according to one of the preceding claims, wherein the plurality of capacitive sensor elements (1312) are arranged in a matrix.

## Patentansprüche

1. Durch physische Kraft bedienbarer kapazitiver Berührungssensor, der aufweist:
ein Substrat (1002);
ein kapazitives Sensorelement auf einer Fläche des Substrats (1002), die eine Vielzahl von Elektroden (1012; 1212) aufweist;
eine Abdeckung (1008; 1208), die einen ersten Abschnitt (1004; 1204) aufweist, der einen im Wesentlichen nicht verformbaren Abstandshalter auf dem Substrat (1002) ausbildet, der das kapazitive Sensorelement (1012; 1212) umgibt, und einen zweiten Abschnitt, der eine flexible Abdeckung ausbildet, die das kapazitive Sensorelement (1012; 1212) abdeckt; und
eine elektrisch leitende Ebene (1006; 1206), die über mehrere Sockel (1030; 1230) mit der flexiblen Abdeckung gekoppelt ist und sich in der Nähe des kapazitiven Sensorelements (1012; 1212) befindet und so angeordnet ist, dass sie jede Elektrode der Vielzahl von Elektroden (1012; 1212) zumindest teilweise abdeckt;
wobei eine Dichte von Sockeln (1030; 1230), die zwischen der flexiblen Abdeckung (1008; 1208) und der elektrisch leitenden Ebene (1006; 1206) gekoppelt sind, größer ist als eine Dichte von Elektroden der Vielzahl von Elektroden (1012; 1212); und
wobei, wenn eine mechanische Kraft auf die flexible Abdeckung (1008) ausgeübt wird, die flexible Abdeckung (1008; 1208) und die elektrisch leitende Ebene (1006; 1206) in Richtung des kapazitiven Sensorelements (1012; 1212) vorgespannt werden, wodurch das kapazitive Sensorelement (1012; 1212) den Kapazitätswert ändert.

2. Durch physische Kraft bedienbarer kapazitiver Berührungssensor gemäß Anspruch 1, wobei die Abdeckung eine einteilige Abdeckung (1008; 1208) ist und die elektrisch leitende Ebene (1006; 1206) ein Teil der einteiligen Abdeckung (1008; 1208) ist.

3. Durch physische Kraft bedienbarer kapazitiver Berührungssensor gemäß Anspruch 1, wobei die Vielzahl von Elektroden (1012; 1212) angeordnet ist, um einen Schieber auszubilden.

4. Durch physische Kraft bedienbarer kapazitiver Berührungssensor gemäß Anspruch 1, wobei die Sockel (1030) in einer Matrix angeordnet sind.

5. Durch physische Kraft bedienbarer kapazitiver Berührungssensor gemäß Anspruch 1, wobei die Vielzahl von Sockeln (1030; 1230) rund, quadratisch oder rechteckig sind.

6. Durch physische Kraft bedienbarer kapazitiver Berührungssensor gemäß Anspruch 4 oder 5, wobei die Vielzahl von kapazitiven Sensorelementen (1212) ringförmig angeordnet ist und die elektrisch leitende Ebene (1206) ringförmig ist.

7. Durch physische Kraft bedienbarer kapazitiver Berührungssensor gemäß Anspruch 4, wobei durch die flexible Abdeckung und den im Wesentlichen nicht verformbaren Abstandshalter (1004; 1204) ein verformbarer Raum (1016; 1206) um das kapazitive Sensorelement (1012; 1212) erzeugt wird, wobei die flexible Abdeckung lichtdurchlässig ist und der verformbare Raum eine Lichtquelle aufweist, wobei die Lichtquelle vorzugsweise zumindest eine Licht emittierende Diode (LED) ist.

8. Durch physische Kraft bedienbarer kapazitiver Berührungssensor gemäß einem der vorhergehenden Ansprüche, wobei zumindest eines aus der elektrisch leitenden Ebene (1006; 1206), dem kapazitiven Sensorelement (1012; 1212) oder dem Substrat (1002) lichtdurchlässig ist und der im Wesentlichen nicht verformbare Abstandshalter (1004; 1204) lichthemmend ist.

9. Durch physische Kraft bedienbarer kapazitiver Berührungssensor gemäß einem der Ansprüche 1 bis 6 und 8, der weiterhin eine Lichtquelle aufweist, vorzugsweise eine Elektrolumineszenz- (EL-) Schicht oder eine organische Licht emittierende Dioden- (OLED-) Schicht oder eine elektrophoretische Beschichtung aus Licht emittierendem Material zum Beleuchten einer Fläche der flexiblen Abdeckung.

10. Durch physische Kraft bedienbarer kapazitiver Berührungssensor gemäß Anspruch 9, wobei die Lichtquelle zwischen der elektrisch leitenden Ebene (1006; 1206) und der flexiblen Abdeckung oder zwischen der elektrisch leitenden Ebene (1006; 1206) und dem kapazitiven Sensorelement (1012; 1212) oder zwischen dem kapazitiven Sensorelement (1012; 1212) und dem Substrat (1002) oder auf einer gegenüberliegenden Seite des Substrats (1002) angeordnet ist, von der aus das kapazitive Sensorelement (1012; 1212) angeordnet ist, wodurch Licht zum Beleuchten der flexiblen Abdeckung durch das Substrat (1002) scheint.

11. Durch physische Kraft bedienbarer kapazitiver Berührungssensor gemäß einem der vorhergehenden Ansprüche, der weiterhin ein alphanumerisches Emblem auf der flexiblen Abdeckung aufweist, um eine Funktion eines zugeordneten kapazitiven Sensorelements (1012; 1212) anzuzeigen, vorzugsweise wobei das alphanumerische Emblem in Siebdruck auf die flexible Abdeckung aufgebracht ist oder das alphanumerische Emblem in die flexible Abdeckung geprägt ist oder das alphanumerische Emblem auf die flexible Abdeckung gestempelt ist.

12. Durch physische Kraft bedienbarer kapazitiver Berührungssensor gemäß einem der vorhergehenden Ansprüche, wobei die elektrisch leitende Ebene (1006) eine Schicht aus Indiumzinnoxid (ITO) ist, die auf einer Fläche der flexiblen Abdeckung angeordnet ist, oder eine Schicht aus Antimonzinnoxid (ATO) ist, die auf einer Fläche der flexiblen Abdeckung angeordnet ist, oder einer Graphen-Schicht ist, die auf einer Fläche der flexiblen Abdeckung angeordnet ist.

13. Durch physische Kraft bedienbarer kapazitiver Berührungssensor gemäß einem der vorhergehenden Ansprüche, wobei das kapazitive Sensorelement (1012; 1212) mit einem Eingang einer Kapazitätswertmessschaltung (404) gekoppelt ist und die elektrisch leitende Ebene (1006; 1206) mit einer gemeinsamen Bezugsleitung einer Energieversorgung oder Masse gekoppelt ist, oder
wobei das kapazitive Sensorelement (1012; 1212) mit einem ersten Eingang einer Kapazitätswertmessschaltung (404) gekoppelt ist, die elektrisch leitende Ebene (1006; 1206) mit einem zweiten Eingang der Kapazitätswertmessschaltung (404) gekoppelt ist und ein Schalter mit der elektrisch leitenden Ebene und einer gemeinsamen Bezugsleitung einer Energieversorgung oder Masse gekoppelt ist, wobei, wenn der Schalter geschlossen ist, die elektrisch leitende Ebene (1006; 1206) mit der gemeinsamen Bezugsleitung der Energieversorgung oder Masse gekoppelt ist und im geöffneten Zustand die elektrisch leitende Ebene mit dem zweiten Eingang der Kapazitätswertmessschaltung (404) operativ verbunden ist.

14. Durch physische Kraft bedienbarer kapazitiver Berührungssensor gemäß einem der vorhergehenden Ansprüche, wobei das Substrat (1002) und das kapazitive Sensorelement (1012) aus einer Leiterplatte hergestellt sind oder wobei das Substrat (1002) Glas, Kunststoff, Metall oder nichtmetallisch ist.

15. Benutzerschnittstelle, die eine Vielzahl von durch physische Kraft bedienbarer kapazitiver Berührungssensoren gemäß einem der vorhergehenden Ansprüche aufweist, wobei die Vielzahl von kapazitiven Sensorelementen (1312) in einer Matrix angeordnet sind.

## Revendications

1. Capteur tactile capacitif de force physique, comprenant :
un substrat (1002) ;
un élément de capteur capacitif sur une face du substrat (1002) comprenant une pluralité d'électrodes (1012 ; 1212) ;
un capot (1008 ; 1208) comprenant une première section (1004 ; 1204) formant un élément d'espacement sensiblement non déformable sur le substrat (1002) qui entoure l'élément de capteur capacitif (1012 ; 1212) et une deuxième section formant un capot souple recouvrant l'élément de capteur capacitif (1012 ; 1212) ; et
un plan électriquement conducteur (1006 ; 1206) accouplé au capot souple par l'intermédiaire d'une pluralité de socles (1030 ; 1230) et qui est à proximité de l'élément de capteur capacitif (1012 ; 1212) et agencé de manière à recouvrir au moins partiellement chaque électrode de ladite pluralité d'électrodes (1012 ; 1212) ;
dans lequel une densité des socles (1030 ; 1230) accouplés entre le capot souple (1008 ; 1208) et le plan électriquement conducteur (1006 ; 1206) est supérieure à une densité des électrodes de la pluralité d'électrodes (1012 ; 1212) ; et
dans lequel, lorsqu'une force mécanique est appliquée au capot souple (1008), le capot souple (1008 ; 1208) et le plan électriquement conducteur (1006 ; 1206) sont sollicités vers l'élément de capteur capacitif (1012 ; 1212), moyennant quoi l'élément de capteur capacitif (1012; 1212) change de valeur de capacitance.

2. Capteur tactile capacitif de force physique selon la revendication 1, dans lequel le capot est un capot d'une seule pièce (1008 ; 1208) et le plan électriquement conducteur (1006 ; 1206) est une partie du capot d'une seule pièce (1008 ; 1208).

3. Capteur tactile capacitif de force physique selon la revendication 1, dans lequel la pluralité d'électrodes (1012 ; 1212) sont agencées de manière à former un coulisseau.

4. Capteur tactile capacitif de force physique selon la revendication 1, dans lequel la pluralité de socles (1030) sont agencés en une matrice.

5. Capteur tactile capacitif de force physique selon la revendication 1, dans lequel la pluralité de socles (1030 ; 1230) sont ronds, carrés, ou rectangulaires.

6. Capteur tactile capacitif de force physique selon la revendication 4 ou 5, dans lequel la pluralité d'éléments de capteur capacitif (1212) sont agencés de manière à former un anneau et le plan électriquement conducteur (1206) est de forme annulaire.

7. Capteur tactile capacitif de force physique selon la revendication 4, dans lequel un espace déformable (1016 ; 1206) autour de l'élément de capteur capacitif (1012 ; 1212) est créé par le capot souple et l'élément d'espacement sensiblement non déformable (1004 ; 1204), dans lequel le capot souple transmet la lumière et l'espace déformable comprend une source de lumière, dans lequel la source de lumière est de préférence au moins une diode électroluminescente (DEL).

8. Capteur tactile capacitif de force physique selon l'une des revendications précédentes, dans lequel au moins l'un du plan électriquement conducteur (1006 ; 1206), de l'élément de capteur capacitif (1012 ; 1212), ou du substrat (1002) transmet la lumière et l'élément d'espacement sensiblement non déformable (1004 ; 1204) est un inhibiteur de lumière.

9. Capteur tactile capacitif de force physique selon l'une quelconque des revendications 1 à 6 et 8,
comprenant en outre une source de lumière, de préférence une couche électroluminescente (EL) ou une couche de diode électroluminescente organique (OLED) ou un revêtement électrophorétique de matériau émettant de la lumière, pour éclairer une face du capot souple.

10. Capteur tactile capacitif de force physique selon la revendication 9, dans lequel la source de lumière est située entre le plan électriquement conducteur (1006 ; 1206) et le capot souple ou entre le plan électriquement conducteur (1006 ; 1206) et l'élément de capteur capacitif (1012 ; 1212) ou entre l'élément de capteur capacitif (1012 ; 1212) et le substrat (1002) ou sur une face opposée du substrat (1002) par rapport à celle sur laquelle l'élément de capteur capacitif (1012 ; 1212) est situé, moyennant quoi la lumière brille à travers le substrat (1002) pour éclairer le capot souple.

11. Capteur tactile capacitif de force physique selon l'une des revendications précédentes, comprenant en outre un symbole alphanumérique sur le capot souple pour indiquer une fonction d'un élément de capteur capacitif (1012 ; 1212) associé, de préférence dans lequel le symbole alphanumérique est sérigraphié sur le capot souple ou le symbole alphanumérique est estampé dans le capot souple ou le symbole alphanumérique est estampillé sur le capot souple.

12. Capteur tactile capacitif de force physique selon l'une des revendications précédentes, dans lequel le plan électriquement conducteur (1006) est une couche d'oxyde d'étain (ITO) disposée sur une face du capot souple ou une couche d'oxyde d'étain-antimoine (ATO) disposée sur une face du capot souple ou une couche de graphène disposée sur une face du capot souple.

13. Capteur tactile capacitif de force physique selon l'une des revendications précédentes, dans lequel l'élément de capteur capacitif (1012 ; 1212) est couplé à une entrée d'un circuit de mesure de valeur de capacitance (404) et le plan électriquement conducteur (1006 ; 1206) est couplé à un commun ou à une masse d'alimentation, ou
dans lequel l'élément de capteur capacitif (1012 ; 1212) est couplé à une première entrée d'un circuit de mesure de valeur de capacitance (404), le plan électriquement conducteur (1006 ; 1206) est couplé à une deuxième entrée du circuit de mesure de valeur de capacitance (404), et un commutateur est couplé au plan électriquement conducteur et à un commun ou à une masse d'alimentation, dans lequel, lorsque le commutateur est fermé, le plan électriquement conducteur (1006 ; 1206) est couplé au commun ou à la masse d'alimentation et, lorsqu'il est ouvert, le plan électriquement conducteur est opérationnel avec la deuxième entrée du circuit de mesure de valeur de capacitance (404).

14. Capteur tactile capacitif de force physique selon l'une des revendications précédentes, dans lequel le substrat (1002) et l'élément de capteur capacitif (1012) sont fabriqués à partir d'une carte de circuit imprimé ou dans lequel le substrat (1002) est en verre, en matière plastique, métallique, ou non métallique.

15. Interface utilisateur comportant une pluralité de capteurs tactiles capacitifs de force physique selon l'une des revendications précédentes, dans laquelle la pluralité d'éléments de capteur capacitif (1312) sont agencés en une matrice.
